# EUROPEAN PATENT APPLICATION

(11) **EP 4 761 496 A1**
(43) Date of publication of application: **17.06.2026**
(21) Application number: 25192646.5
(22) Date of filing: 29.07.2025
(51) Int. Cl.: H10B 41/27, H10B 41/50, H10B 43/27, H10B 43/50

(54) **SEMICONDUCTOR MEMORY DEVICE AND ELECTRONIC SYSTEM INCLUDING THE SAME**

(30) Priority: 12.12.2024 KR 20240184754
(71) Applicant: Samsung Electronics Co., Ltd., Suwon-si, Gyeonggi-do 16677 (KR)
(72) Inventor: KIM, Hyun Ji, 16677 Suwon-si (KR); KIM, Hyeong Jin, 16677 Suwon-si (KR); SON, Bu Myeong, 16677 Suwon-si (KR); SONG, Young In, 16677 Suwon-si (KR); YOON, Taek Kyu, 16677 Suwon-si (KR); HAN, Jee Hoon, 16677 Suwon-si (KR)
(74) Representative: Marks & Clerk LLP

(57) **Abstract**

A semiconductor memory device includes a stacked structure including mold insulating films and gate electrodes alternately stacked in a vertical direction; a gate contact penetrating at least a part of the stacked structure and electrically connected to one of the gate electrodes; a first spacer on sidewalls of the gate contact; and a second spacer between the gate contact and the first spacer. The gate contact includes an extension portion extending in the vertical direction and a bulge portion protruding in a horizontal direction at one end of the extension portion and contacting the one of the gate electrodes, and at least a part of a bottom surface of the second spacer contacts the bulge portion.

## Description

### BACKGROUND

### 1. Field

The present disclosure relates to a semiconductor memory device and an electronic system including the same, and more specifically, to a semiconductor memory device including memory cells arranged three-dimensionally and an electronic system including the semiconductor memory device.

### 2. Description of the Related Art

As semiconductor memory devices capable of storing large amounts of data are required in electronic systems, research is being conducted on methods to increase the data storage capacity of semiconductor memory devices. As one such method, a semiconductor memory device including memory cells arranged three-dimensionally instead of two-dimensionally has been proposed.

### SUMMARY

An objective of the present disclosure is to provide a semiconductor memory device with improved performance and reliability.

Another objective of the present disclosure is to provide an electronic system including a semiconductor memory device with improved performance and reliability.

The objectives of the present disclosure are not limited to those mentioned above, and other objectives not explicitly stated will be clearly understood by those skilled in the art based on the following description.

According to an aspect of the present disclosure, a semiconductor memory device includes a stacked structure including mold insulating films and gate electrodes alternately stacked in a vertical direction; a gate contact penetrating at least a part of the stacked structure and electrically connected to one of the gate electrodes; a first spacer on sidewalls of the gate contact; and a second spacer between the gate contact and the first spacer. The gate contact includes an extension portion extending in the vertical direction and a bulge portion protruding in a horizontal direction at one end of the extension portion and contacting the one of the gate electrodes, and at least a part of a bottom surface of the second spacer contacts the bulge portion.

According to an aspect of the present disclosure, a semiconductor memory device includes a first substrate; a stacked structure on the first substrate, the stacked structure including mold insulating films and gate electrodes alternately stacked; a gate contact penetrating at least a part of the stacked structure and electrically connected to one of the gate electrodes; a first spacer on sidewalls of the gate contact; and a second spacer between the gate contact and the first spacer, the second spacer including polysilicon.

According to an aspect of the present disclosure, an electronic system includes a main substrate; a semiconductor memory device on the main substrate; and a controller electrically connected to the semiconductor memory device, on the main substrate. The semiconductor memory device includes: a stacked structure including mold insulating films and gate electrodes alternately stacked; a gate contact penetrating at least a part of the stacked structure and electrically connected to one of the gate electrodes; a first spacer on sidewalls of the gate contact; and a second spacer including polysilicon, between the gate contact and the first spacer.

It should be noted that the effects of the present disclosure are not limited to those described above, and other effects of the present disclosure will be apparent from the following description.

At least some of the above and other features of the invention are set out in the claims.

### BRIEF DESCRIPTION OF THE DRAWINGS

The above and other aspects and features of the present disclosure will become more apparent by describing in detail example embodiments thereof with reference to the attached drawings, in which:
FIG. 1 is an example layout diagram illustrating a semiconductor memory device according to some embodiments;
FIG. 2 is a cross-sectional view taken along line A-A' of FIG. 1;
FIG. 3 is an enlarged view of region R1 of FIG. 2;
FIG. 4 is a cross-sectional view illustrating a semiconductor memory device according to some embodiments;
FIG. 5 is a cross-sectional view illustrating a semiconductor memory device according to some embodiments;
FIG. 6 is an enlarged view of region R2 of FIG. 5;
FIG. 7 is a cross-sectional view illustrating a semiconductor memory device according to some embodiments;
FIG. 8 is an enlarged view of region R3 of FIG. 7;
FIGS. 9 through 15 are diagrams illustrating intermediate steps of a method for manufacturing a semiconductor device according to some embodiments;
FIG. 16 is an example block diagram illustrating an electronic system according to some embodiments;
FIG. 17 is an example perspective view illustrating an electronic system according to some embodiments; and
FIG. 18 is a schematic cross-sectional view taken along line I-I' of FIG. 17.

### DETAILED DESCRIPTION

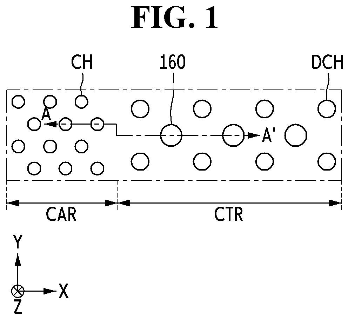

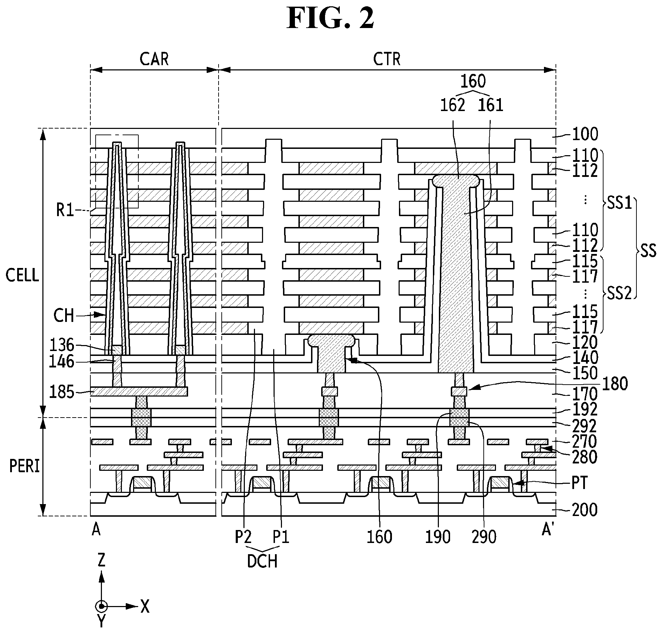

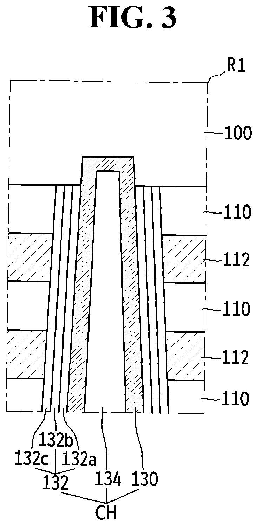

FIG. 1 is an example layout diagram illustrating a semiconductor memory device according to some embodiments. FIG. 2 is a cross-sectional view taken along line A-A' of FIG. 1. FIG. 3 is an enlarged view of region R1 of FIG. 2.

Referring to FIGS. 1 through 3, the semiconductor memory device according to some embodiments includes a cell structure CELL and a peripheral circuit structure PERI.

The memory cell structure CELL may include a cell array region CAR and a contact region CTR.

A memory cell array including a plurality of memory cells may be formed in the cell array region CAR. For example, the cell array region CAR may include channel structures CH, gate electrodes (112 and 117), and conductive lines 185.

The contact region CTR may be arranged around the cell array region CAR. For example, the contact region CTR may be adjacent to the cell array region CAR in a first direction X. For example, gate contacts 160 may be disposed in the contact region CTR.

The memory cell structure CELL may include a first substrate 100, a stacked structure SS, channel structures CH, the gate contacts 160, and a first wiring structure 180.

The first substrate 100 may include, for example, a semiconductor substrate such as a silicon (Si) substrate, a germanium (Ge) substrate, or a silicon-germanium (SiGe) substrate. Alternatively, the first substrate 100 may include a silicon-on-insulator (SOI) substrate or a germanium-on-insulator (GOI) substrate.

In some embodiments, the first substrate 100 may include a conductive film. The conductive film may include, for example, impurity-doped polysilicon, a metal, or a metal silicide. The conductive film may be formed as a single layer or as a multilayer. For example, the first substrate 100 may be an n-type semiconductor substrate including n-type impurities such as phosphorus (P) or arsenic (As). In another example, the first substrate 100 may include a first conductive film, which includes a metal silicide such as tungsten silicide (WSi), and a second conductive film, which is stacked on the first conductive film and includes impurity-doped polysilicon. The first substrate 100 may be provided as a common source line of the semiconductor device according to some embodiments.

In some embodiments, an insulating region may be formed in at least a portion of the contact region CTR within the first substrate 100. The insulating region may include, for example, at least one of silicon oxide, silicon nitride, silicon oxynitride, or silicon carbide, but is not limited thereto.

In the following description, a first surface on which the stacked structure SS is disposed may be referred to as the front side of the first substrate 100, and a second surface opposite to the first surface may be referred to as the back side of the first substrate 100. Also, a first direction X and a second direction Y, which are directions parallel to the front side of the first substrate 100, may intersect (e.g., be perpendicular) to each other. Additionally, a third direction Z, which is a direction perpendicular to the front side of the first substrate 100, may intersect (e.g., be perpendicular to) the first and second directions X and Y. The first and second directions X and Y may also be referred to as horizontal directions, and the third direction Z may also be referred to as a vertical direction. The terms "upper," "lower," top," "bottom," "upper surface," "lower surface," and "bottom surface," as used herein, are defined based on the front side of the first substrate 100.

The stacked structure SS may be formed on the first substrate 100. The stacked structure SS may include a plurality of mold insulating films (110 and 115) and a plurality of gate electrodes (112 and 117) alternately stacked on the first substrate 100. The gate electrodes (112 and 117) may be sequentially stacked and spaced apart from each other by the mold insulating films (110 and 115).

Each of the mold insulating films (110 and 115) and each of the gate electrodes (112 and 117) may have a layered structure extending along a horizontal plane (e.g., an XY plane). In the contact region CTR and the cell array region CAR, the mold insulating films (110 and 115) and the gate electrodes (112 and 117) extend longitudinally in the first and second directions X and Y. The lengths of the gate electrodes (112 and 117) extending in the first direction X are identical to each other, and the lengths of the gate electrodes (112 and 117) extending in the second direction Y are also identical. In the contact region CTR and the cell array region CAR, gate electrodes 112 closest to the first substrate 100 entirely overlap with gate electrodes 117 farthest from the first substrate 100, for example, in the third direction Z. That is, the stacked structure SS does not include a step structure in the contact region CTR and the cell array region CAR.

For example, the stacked structure SS may include a plurality of gate stacks (e.g., first gate stacks SS1 and second gate stacks SS2) sequentially stacked on the first substrate 100. Two types of gate stacks are illustrated as being stacked on the first substrate 100, but this is merely an example. The number of types of gate stacks stacked on the first substrate 100 may be three or greater.

The first gate stacks SS1 may include first mold insulating films 110 and first gate electrodes 112 alternately stacked on the first substrate 100. In some embodiments, the first gate electrodes 112 may include at least one ground selection line and a plurality of first wordlines sequentially stacked on the first substrate 100. The numbers of the first mold insulating films 110 and the first gate electrodes 112 are merely an example and are not limited to what is illustrated.

The second gate stacks SS2 may include second mold insulating films 115 and second gate electrodes 117 alternately stacked on the first gate stacks SS1. In some embodiments, the second gate electrodes 117 may include a plurality of second wordlines and at least one string selection line sequentially stacked on the first gate stacks SS1. The numbers of the second mold insulating films 115 and the second gate electrodes 117 are merely an example and are not limited to what is illustrated.

The gate electrodes (112 and 117) may each include a conductive material such as a metal, for example, tungsten (W), molybdenum (Mo), ruthenium (Ru), cobalt (Co), or nickel (Ni), or a semiconductor material such as Si. For example, the gate electrodes (112 and 117) may each include at least one of W, Mo, or Ru. In another example, the gate electrodes (112 and 117) may each include polysilicon.

The mold insulating films (110 and 115) may each include, for example, at least one of silicon oxide, silicon nitride, or silicon oxynitride, but are not limited thereto. For example, the mold insulating films (110 and 115) may each include a silicon oxide film.

An interlayer insulating film 120 may cover the stacked structure SS. The interlayer insulating film 120 may cover the second gate stacks SS2. The interlayer insulating film 120 may include, for example, at least one of silicon oxide, silicon oxynitride, or a low-k material with a dielectric constant smaller than that of silicon oxide, but is not limited thereto.

The channel structures CH may be disposed in the cell array region CAR. The channel structures CH may extend in the vertical direction (e.g., the third direction Z) and intersect the gate electrodes (112 and 117). For example, the channel structures CH may extend in the third direction Z and penetrate the stacked structure SS. The channel structures CH may be pillar-shape (e.g., cylindrical) structures extending in the third direction Z.

In some embodiments, a plurality of channel structures CH may be arranged in a zigzag fashion. For example, as illustrated in FIG. 1, the channel structures CH may be arranged to be staggered in the first and second directions X and Y. The channel structures CH may further improve the integration density of the semiconductor memory device according to some embodiments. The number and arrangement of the channel structures CH are merely examples and are not limited to what is illustrated.

Each of the channel structures CH may include a semiconductor film 130 and a data storage film 132.

The semiconductor films 130 of the channel structures CH may extend in the third direction Z and intersect the gate electrodes (112 and 117). The semiconductor films 130 are illustrated as having a cup shape, but this is merely an example. For example, the semiconductor films 130 may have various other shapes such as a cylindrical shape, a rectangular column shape, or a solid pillar shape. The semiconductor films 130 may include, for example, a semiconductor material such as single-crystal silicon, polysilicon, organic semiconductor material, or carbon nanostructures, but is not limited thereto. In some embodiments, the semiconductor films 130 may include a polysilicon film.

The data storage films 132 of the channel structures CH may be interposed between the semiconductor films 130 and the gate electrodes (112 and 117). For example, the data storage films 132 may extend along the outer side surfaces of the semiconductor films 130. The data storage films 132 may include, for example, at least one of silicon oxide, silicon nitride, silicon oxynitride, or a high-k material with a dielectric constant greater than that of silicon oxide, but is not limited thereto. The high-k material may include, for example, aluminum oxide, hafnium oxide, lanthanum oxide, tantalum oxide, titanium oxide, lanthanum hafnium oxide, lanthanum aluminum oxide, dysprosium scandium oxide, or a combination thereof.

In some embodiments, the data storage films 132 may be formed as multi-layered films. For example, as illustrated in FIG. 3, the data storage films 132 may each include a tunnel insulating film 132a, a charge storage film 132b, and a blocking insulating film 132c sequentially stacked on the outer side surfaces of the corresponding semiconductor film 130.

The tunnel insulating films 132a of the data storage films 132 may include, for example, silicon oxide or a high-k material having a dielectric constant greater than that of silicon oxide, such as aluminum oxide (Al₂O₃) or hafnium oxide (HfO₂). The charge storage films 132b of the data storage films 132 may include, for example, silicon nitride. The blocking insulating films 132c of the data storage films 132 may include, for example, silicon oxide or a high-k material having a dielectric constant greater than that of silicon oxide, such as Al₂O₃ or HfO₂.

In some embodiments, the semiconductor films 130 may be electrically connected to the first substrate 100. For example, first ends (e.g., the lower ends) of the semiconductor film 130 may be exposed from the data storage films 132 and contact the first substrate 100.

In some embodiments, the semiconductor films 130 may penetrate the front side of the first substrate 100. For example, the first ends (e.g., the lower end) of the semiconductor films 130 may protrude below the data storage films 132. The semiconductor films 130 may reduce contact resistance by improving the contact area with the first substrate 100.

In some embodiments, each of the channel structures CH may further include a filling insulating film 134. The filling insulating films 134 of the channel structures CH may be formed to fill the interior of the cup-shaped semiconductor films 130. The filling insulating films 134 may include an insulating material such as silicon oxide, but is not limited thereto.

In some embodiments, each of the channel structures CH may further include a channel pad 136. The channel pads 136 of the channel structures CH may be electrically connected to second ends (e.g., the upper ends) of the semiconductor films 130. The channel pads 136 may include a conductive material such as impurity-doped polysilicon, a metal, or a metal silicide, but is not limited thereto.

In some embodiments, dummy channel structures DCH may be formed in the contact region CTR. The dummy channel structures DCH may extend in the third direction Z and at least partially penetrate the stacked structure SS. The size (e.g., width) of the dummy channel structures DCH may be the same as or different from the size of the channel structures CH. In some embodiments, the size of the dummy channel structures DCH may be greater than the size of the channel structures CH.

In some embodiments, each of the dummy channel structures DCH may include a first portion P1 extending in the third direction Z and a second portion P2 extending in a horizontal direction (e.g., the first direction X and/or the second direction Y) from the first portion P1. The second portion P2 may protrude toward the gate electrodes (112 and 117) from the first portion P1. In a direction parallel to the front side of the first substrate 100, the width of the second portion P2 may be greater than the width of the first portion P1.

The dummy channel structures DCH may be formed at a different level than the channel structures CH or at the same level as the channel structures CH. For example, when the dummy channel structures DCH are formed at a different level than the channel structures CH, the dummy channel structures DCH may be filled with an insulating material and/or a conductive material. In another example, when the dummy channel structures DCH are formed at the same level as the channel structures CH, the dummy channel structures DCH may include the semiconductor films 130, the data storage films 132, the filling insulating films 134, and the channel pads 136 described above.

In some embodiments, each of the channel structures CH and/or each of the dummy channel structures DCH may have a step difference due to a width difference. For example, the side surfaces of each of the channel structures CH and/or the side surfaces of each of dummy channel structures DCH may have bent portions near the boundary between the first gate stacks SS1 and the second gate stacks SS2.

For example, the channel structures CH may include first channel structures and second channel structures on the first channel structures, and the second channel structures may be connected to the first channel structures. At the boundaries between the first channel structures and the second channel structures, the width of the first channel structures may be greater than the width of the second channel structures. The channel structures CH may have bent portions at the boundaries between the first channel structures and the second channel structures.

The gate contacts 160 may be disposed in the contact region CTR. A plurality of gate contacts 160 may be electrically connected to corresponding gate electrodes (112 and 117). For example, the gate contacts 160 may each extend in the third direction Z and penetrate at least a portion of the stacked structure SS to be connected to one of the gate electrodes (112 and 117). The number of gate electrodes (112 and 117) penetrated by each of the gate contacts 160 may differ.

Each of the gate contacts 160 includes an extension portion 161 and an expansion portion 162 (e.g., a bulge portion).

The extension portions 161 of the gate contacts 160 extend in the third direction Z. The width of the extension portions 161 may decrease toward the first substrate 100. The extension portions 161 may have no step difference. The extension portions 161 may not include bent portions. For example, at a first height from the first substrate 100, the channel structures CH and/or the dummy channel structures DCH may include bent portions, but the extension portions 161 may not include bent portions.

The expansion portions 162 of the gate contacts 160 are connected to ends of the extension portions 161. The expansion portions 162 are connected to the lower ends of the extension portions 161 in the third direction Z. The expansion portions 162 form the lowest parts of the gate contacts 160. The expansion portions 162 may bulge in a horizontal direction (e.g., the first direction X and/or the second direction Y). The expansion portions 162 may bulge toward the stacked structure SS. The expansion portions 162 may bulge toward the corresponding mold insulating films (110 and 115). In a direction parallel to the front side of the first substrate 100 (e.g., the first direction X and/or the second direction Y), the width of the expansion portions 162 may increase and then decrease away from the first substrate 100. The expansion portions 162 may contact the corresponding gate electrodes (112 and 117). The lower surfaces of the expansion portions 162 may contact the upper surfaces of the corresponding gate electrodes (112 and 117).

For example, in the third direction Z, the thickness of the expansion portions 162 may be smaller than the thickness of the first mold insulating films 110 and the second mold insulating films 115. The upper surfaces of the expansion portions 162 may be located within the corresponding mold insulating film (110 and 115).

At the boundaries between the extension portions 161 and the expansion portions 162, the width of the expansion portions 162 in a direction parallel to the front side of the first substrate 100 (e.g., the first direction X and/or the second direction Y) may be greater than the width of the extension portions 161 in the same direction.

Each of the gate contacts 160 may include a conductive material, for example, at least one of W, copper (Cu), aluminum (Al), or an alloy thereof.

First spacers 140 extend along at least portions of the sidewalls of the gate contacts 160. The first spacers 140 extend along the sidewalls of the extension portions 161 of the gate contacts 160. The first spacers 140 may surround the sidewalls of the extension portions 161. The first spacers 140 may further extend along the upper surface of the stacked structure SS. The first spacers 140 may further extend along the interlayer insulating film 120.

The first spacers 140 may extend along at least portions of the sidewalls of the expansion portions 162. The first spacers 140 may be formed between at least portions of the expansion portions 162 and the stacked structure SS. The first spacers 140 may contact at least portions of the expansion portions 162. The lower surfaces of the expansion portions 162 may be positioned below the lower surfaces of the corresponding first spacers 140. For example, the upper surfaces of the first spacers 140 on the gate contacts 160 may be respectively located within the mold insulating films (110 and 115) immediately below the gate electrodes (112 and 117).

Second spacers 150 extend along at least portions of the sidewalls of the gate contacts 160. The second spacers 150 are formed between the first spacers 140 and the gate contacts 160. The second spacers 150 extend along the sidewalls of the extension portions 161 of the gate contacts 160. The second spacers 150 may surround the sidewalls of the extension portions 161. The second spacers 150 may be formed between the extension portions 161 and the stacked structure SS. The second spacers 150 may overlap with at least portions of the expansion portions 162 in the third direction Z. The expansion portions 162 may be disposed between the corresponding gate electrodes (112 and 117) and the second spacers 150. The bottom surfaces of the second spacers 150 may contact at least portions of the expansion portions 162. The bottom surfaces of the second spacers 150 may be located above the bottom surfaces of the first spacers 140.

In some embodiments, the second spacers 150 may further extend along the upper surface of the stacked structure SS. The second spacers 150 may further extend along the first spacers 140 on the interlayer insulating film 120. Second spacers 150 on neighboring gate contacts 160 may be connected to each other.

The first spacers 140 and the second spacers 150 include different insulating materials. The gate contacts 160 may be electrically insulated from gate electrodes (112 and 117) that are not electrically connected to the corresponding gate contacts 160, by the first spacers 140 and the second spacers 150.

The second spacers 150 may include a different material from the first spacers 140, the mold insulating films (110 and 115), and the interlayer insulating film 120. The second spacers 150 may include a material having an etching selectivity with respect to the first spacers 140. The second spacers 150 may include a material having an etching selectivity with respect to the mold insulating films (110 and 115) and the interlayer insulating film 120. For example, the second spacers 150 may include polysilicon, and the first spacers 140 may include silicon oxide. The second spacers 150 may include insulating polysilicon without being subject to a heat treatment process and/or doping process.

The first wiring structure 180 may be formed on the interlayer insulating film 120. The first wiring structure 180 may be electrically connected to the first substrate 100, the gate electrodes (112 and 117), and/or the channel structures CH. For example, a first inter-wiring insulating film 170 may be formed on the interlayer insulating film 120. The first wiring structure 180 may be formed within the first inter-wiring insulating film 170 and be connected to a source layer 102, the gate electrodes (112 and 117), and/or the channel structures CH. The number of layers and the arrangement of the first wiring structure 180 are merely examples and are not limited to what is illustrated.

The first wiring structure 180 may include a conductive material, for example, at least one of Al, Cu, W, Mo, Co, Ru, or an alloy thereof, but is not limited thereto.

In some embodiments, the first wiring structure 180 may include conductive lines 185 arranged within the cell array region CAR. The conductive lines 185 may extend longitudinally in the second direction Y. A plurality of conductive lines 185 may extend in the second direction Y and may be spaced apart from each other to be arranged along the first direction X.

The conductive lines 185 may be electrically connected to a plurality of channel structures CH arranged in the second direction Y. For example, channel contacts 146 may be formed to extend in the third direction Z and connect the channel pads 136 to the conductive lines 185. The conductive lines 185 may be connected to the first ends (e.g., the lower ends) of the semiconductor films 130 through the channel contacts 146 and the channel pads 136. The conductive lines 185 may be provided as bitlines of the semiconductor memory device according to some embodiments.

The peripheral circuit structure PERI may include a second substrate 200, peripheral circuit elements PT, and a second wiring structure 280.

The second substrate 200 may include, for example, a semiconductor substrate such as a Si substrate, a Ge substrate, or a SiGe substrate. Alternatively, the second substrate 200 may include an SOI substrate or a GOI substrate.

The peripheral circuit elements PT may be formed on the second substrate 200. The peripheral circuit elements PT may form peripheral circuits that control the operation of the semiconductor memory device according to some embodiments. For example, the peripheral circuit elements PT may include control logic, row decoders, and page buffers. In the following description, the surface of the second substrate 200 on which the peripheral circuit elements PT are disposed may be referred to as the front side of the second substrate 200, and the surface opposite to the front side of the second substrate 200 may be referred to as the back side of the second substrate 200.

The peripheral circuit elements PT may include, for example, transistors, but are not limited thereto. For example, the peripheral circuit elements PT may include various active elements such as transistors, as well as various passive elements such as capacitors, resistors, and inductors.

The second wiring structure 280 may be formed on the peripheral circuit elements PT. For example, a second inter-wiring insulating film 270 may be formed on the front side of the second substrate 200. The second wiring structure 280 may be formed within the second inter-wiring insulating film 270 and be electrically connected to the peripheral circuit elements PT. The number of layers and the arrangement of the second wiring structure 280 are merely examples and are not limited to what is illustrated.

In some embodiments, the memory cell structure CELL may be stacked on the peripheral circuit structure PERI. For example, the memory cell structure CELL may be stacked on the second inter-wiring insulating film 270.

In some embodiments, the front side of the first substrate 100 may face the peripheral circuit structure PERI. For example, the stacked structure SS may be interposed between the first substrate 100 and the peripheral circuit structure PERI.

The semiconductor device according to some embodiments may have a chip-to-chip (C2C) structure. The C2C structure refers to a structure obtained by fabricating an upper chip including the memory cell structure CELL on a first wafer, fabricating a lower chip including the peripheral circuit structure PERI on a second wafer different from the first wafer, and bonding the upper and lower chips together.

For example, the bonding of the upper and lower chips may involve connecting first bonding metals 190 (and/or a first bonding insulating film 192) formed on the uppermost metal layer of the upper chip to second bonding metals 290 (and/or a second bonding insulating film 292) formed on the uppermost metal layer of the lower chip. For example, when the first bonding metals 190 and the second bonding metals 290 are formed of Cu, a Cu-Cu bonding method may be used. However, this is merely an example, and the first bonding metals 190 and the second bonding metals 290 may be formed of various other metals such as Al or W.

As the first bonding metals 190 and the second bonding metals 290 are bonded, the first wiring structure 180 may be electrically connected to the second wiring structure 280. Accordingly, a plurality of memory cells formed in the cell array region CAR may be electrically connected to the peripheral circuit elements PT.

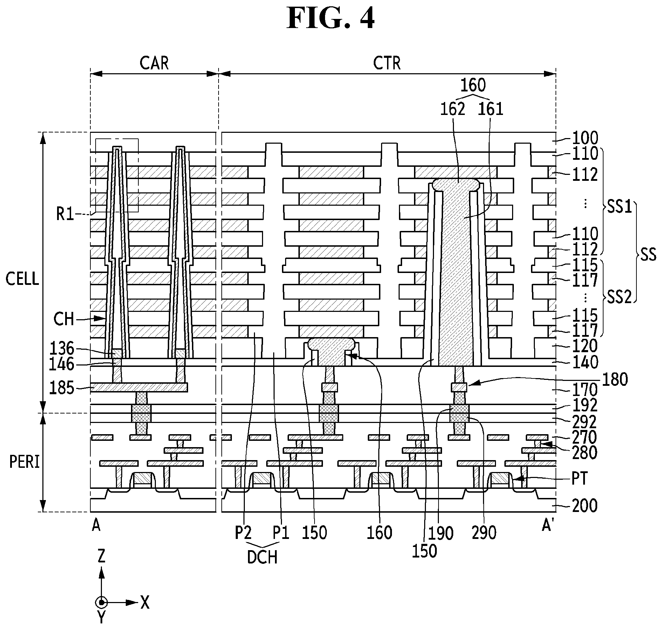

FIG. 4 is a cross-sectional view illustrating a semiconductor memory device according to some embodiments. For convenience of explanation, redundant descriptions previously explained with reference to FIGS. 1 through 3 will be briefly described or omitted. For reference, FIG. 4 is a cross-sectional view taken along line A-A' of FIG. 1.

Referring to FIG. 4, in the semiconductor memory device according to some embodiments, second spacers 150 on corresponding gate contacts 160 may be separated from each other. The second spacers 150 do not extend along the upper surface of a stacked structure SS. The second spacers 150 may extend along at least portions of the sidewalls of the corresponding gate contacts 160.

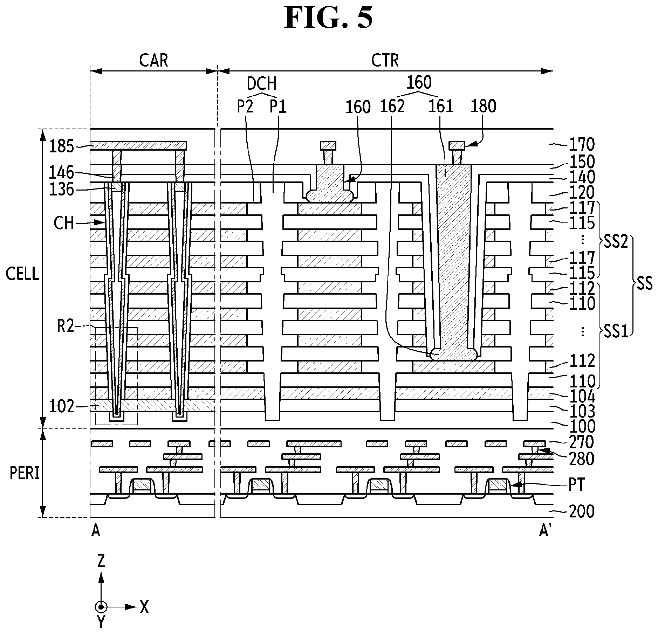

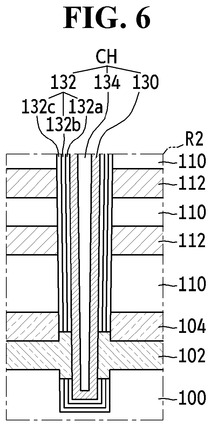

FIG. 5 is a cross-sectional view illustrating a semiconductor memory device according to some embodiments. FIG. 6 is an enlarged view of region R2 of FIG. 5. For convenience of explanation, redundant descriptions previously explained with reference to FIGS. 1 through 3 will be briefly described or omitted. For reference, FIG. 5 is a cross-sectional view taken along line A-A' of FIG. 1.

Referring to FIGS. 5 and 6, the semiconductor memory device according to some embodiments may further include a source layer 102, a source sacrificial layer 103, and a source support layer 104.

The source layer 102 may be formed on the front side of a first substrate 100. The source layer 102 may be interposed between the first substrate 100 and a stacked structure SS. For example, the source layer 102 may extend conformally along the front side of the first substrate 100. The source layer 102 may be electrically connected to a semiconductor film 130. For example, the source layer 102 may contact the side surfaces of the semiconductor film 130 by penetrating a data storage film 132. In some embodiments, the source layer 102 may be formed on part of the first substrate 100 in a cell array region CAR and may not be formed on part of the first substrate 100 in a contact region CTR.

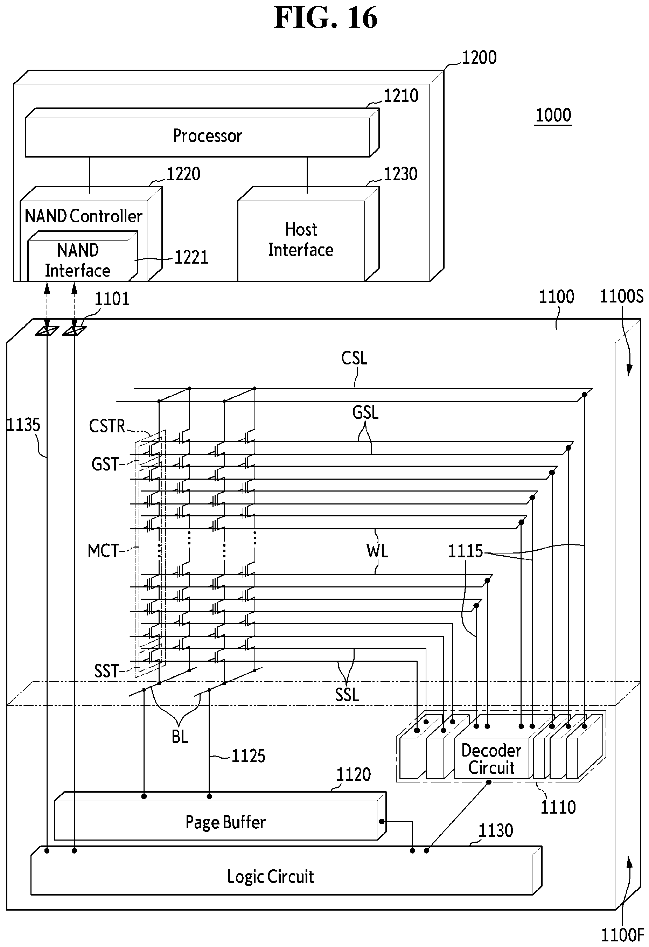

The source layer 102 may include a conductive material such as impurity-doped polysilicon or a metal, but is not limited thereto. The first substrate 100 and the source layer 102 may be provided as a common source line (e.g., "CSL" of FIG. 16) of the semiconductor device according to some embodiments.

The source sacrificial layer 103 may be formed on the part of the first substrate 100 in the contact region CTR. The source sacrificial layer 103 may be disposed at the same level as the source layer 102. As used herein, "at the same level" means being positioned at the same height relative to the front side of the first substrate 100. For example, the lower surface of the source sacrificial layer 103 may be positioned at the same height as the lower surface of the source layer 102.

The source sacrificial layer 103 may be a layer that remains after being partially replaced by the source layer 102. In this case, the thickness of the source layer 102 may be equal to the thickness of the source sacrificial layer 103. For example, the upper surface of the source sacrificial layer 103 may be positioned at the same height as the upper surface of the source layer 102.

The source sacrificial layer 103 may include an insulating material such as at least one of silicon oxide, silicon nitride, or silicon oxynitride, but is not limited thereto. In some embodiments, the source sacrificial layer 103 may include a material having an etching selectivity with respect to mold insulating films (110 and 115). For example, the mold insulating films (110 and 115) may each include a silicon oxide film, and the source sacrificial layer 103 may include a silicon nitride film.

The source support layer 104 may be formed on the first substrate 100, the source layer 102, and the source sacrificial layer 103. For example, the source support layer 104 may extend conformally along the upper surfaces of the first substrate 100, the source layer 102, and the source sacrificial layer 103.

The source support layer 104 may include a material having an etching selectivity with respect to the source sacrificial layer 103. For example, the source sacrificial layer 103 may include a silicon nitride film, and the source support layer 104 may include a polysilicon film. In some embodiments, the first substrate 100, the source layer 102, and the source support layer 104 may be provided as a common source line of the semiconductor device according to some embodiments.

The back side of the first substrate 100 may face a peripheral circuit structure PERI. For example, the first substrate 100 may be interposed between the stacked structure SS and the peripheral circuit structure PERI.

For example, a through via extending in the third direction Z to electrically connect a first wiring structure 180 and a second wiring structure 280 may be provided. Accordingly, a plurality of memory cells formed in the cell array region CAR may be electrically connected to peripheral circuit elements PT.

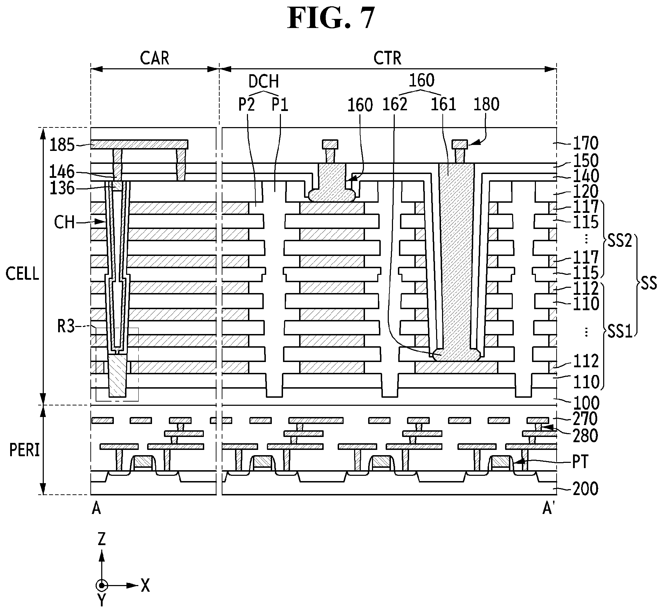

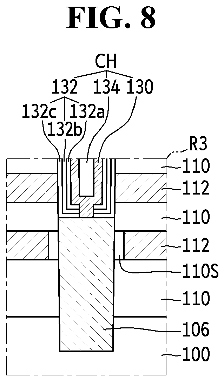

FIG. 7 is a cross-sectional view illustrating a semiconductor memory device according to some embodiments. FIG. 8 is an enlarged view of region R3 of FIG. 7. For convenience of explanation, redundant descriptions previously explained with reference to FIGS. 1 through 3 will be briefly described or omitted. For reference, FIG. 7 is a cross-sectional view taken along line A-A' of FIG. 1.

Referring to FIGS. 7 and 8, in the semiconductor memory device according to some embodiments, a channel structure CH may further include a source pattern 106.

The source pattern 106 may be formed on a first substrate 100. The source pattern 106 may be interposed between the first substrate 100 and a semiconductor film 130 and between the first substrate 100 and a data storage film 132. The source pattern 106 may be electrically connected to the semiconductor film 130. For example, a first end (e.g., the lower end) of the semiconductor film 130 may penetrate the lower portion of the data storage film 132 and contact the source pattern 106.

The source pattern 106 may include a conductive material such as impurity-doped polysilicon or a metal, but is not limited thereto. In some embodiments, the source pattern 106 may be formed by a selective epitaxial growth process from the first substrate 100. The first substrate 100 and the source pattern 106 may be provided as a common source line of the semiconductor device according to some embodiments.

For example, the lower portion of the source pattern 106 may be embedded in the first substrate 100. In another example, the lower surface of the source pattern 106 may be positioned substantially on the same plane as the upper surface of the first substrate 100.

In some embodiments, the upper surface of the source pattern 106 may intersect some of gate electrodes (112 and 117). For example, the upper surface of the source pattern 106 may be formed higher than the upper surface of a lowermost gate electrode 112. In this case, a gate insulating film 110S may be interposed between the source pattern 106 and the gate electrode intersecting the source pattern 106 (e.g., the lowermost gate electrode 112).

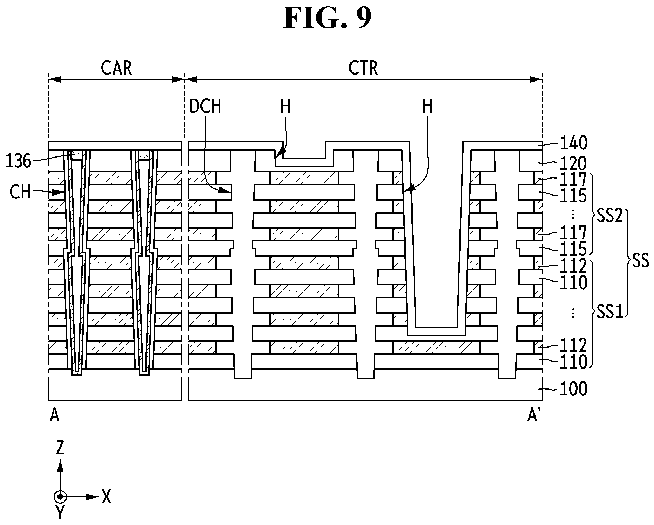

FIGS. 9 through 15 are diagrams illustrating intermediate steps of a method for manufacturing a semiconductor device according to some embodiments. For convenience of explanation, redundant descriptions previously explained with reference to FIGS. 1 through 8 will be briefly described or omitted.

Referring to FIG. 9, a stacked structure SS, an interlayer insulating film 120, channel structures CH, and dummy channel structures DCH may be formed on a first substrate 100. The stacked structure SS may include a plurality of mold insulating films (110 and 115) and a plurality of gate electrodes (112 and 117) alternately stacked. The interlayer insulating film 120 may be formed on the stacked structure SS. The channel structures CH and the dummy channel structures DCH may penetrate the interlayer insulating film 120 and the stacked structure SS. The channel structures CH may be formed in a cell array region CAR, and the dummy channel structures DCH may be formed in a contact region CTR.

Thereafter, contact holes H may be formed. The contact holes H may be formed in the contact region CTR. The contact holes H may penetrate at least portions of the stacked structure SS. The bottom surfaces of the contact holes H may be located within the mold insulating films (110 and 115) above the gate electrodes (112 and 117).

Thereafter, first spacers 140 may be formed on the contact holes H and the interlayer insulating film 120. The first spacers 140 may extend along the contact holes H and the interlayer insulating film 120.

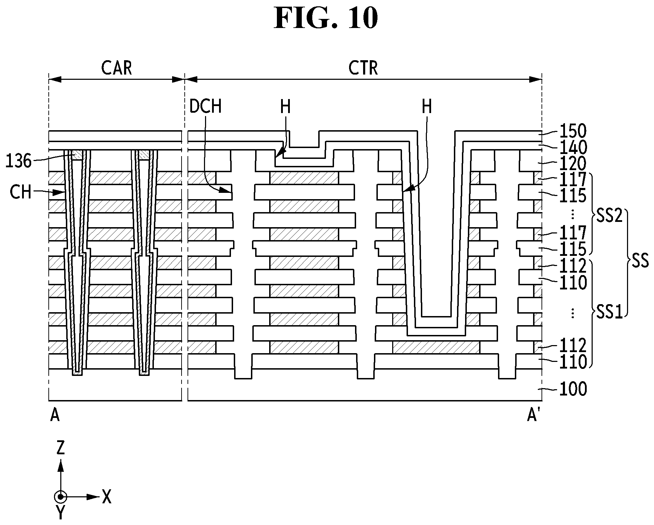

Referring to FIG. 10, second spacers 150 may be formed on the first spacers 140. The second spacers 150 may extend along the first spacers 140. The second spacers 150 and the first spacers 140 may include different insulating materials. The second spacers 150 may include a material having etching selectivity with respect to the first spacers 140. For example, the second spacers 150 may include polysilicon, and the first spacers 140 may include silicon oxide. The second spacers 150 may include insulating polysilicon without being subject to a heat treatment process and/or a doping process.

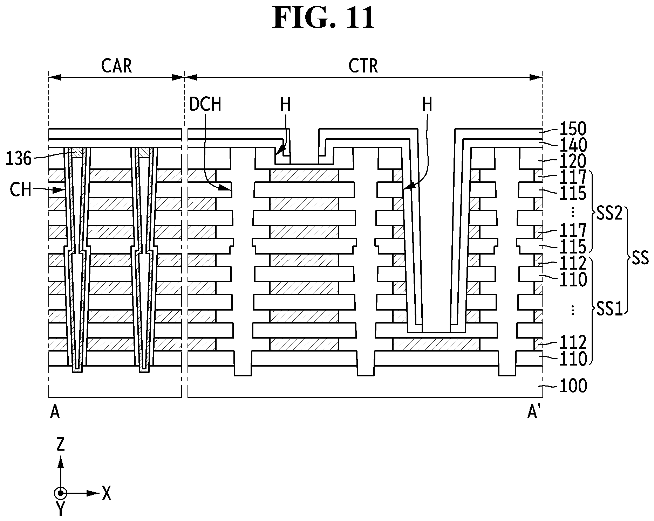

Referring to FIG. 11, portions of the second spacers 150 and first spacers 140 on the bottom surfaces of the contact holes H may be removed. The portions of the first spacers 140 and second spacers 150 may be removed by, for example, an etch-back process. At this time, portions of the mold insulating films (110 and 115) exposed by the removal of the portions of the first spacers 140 and second spacers 150 may also be removed.

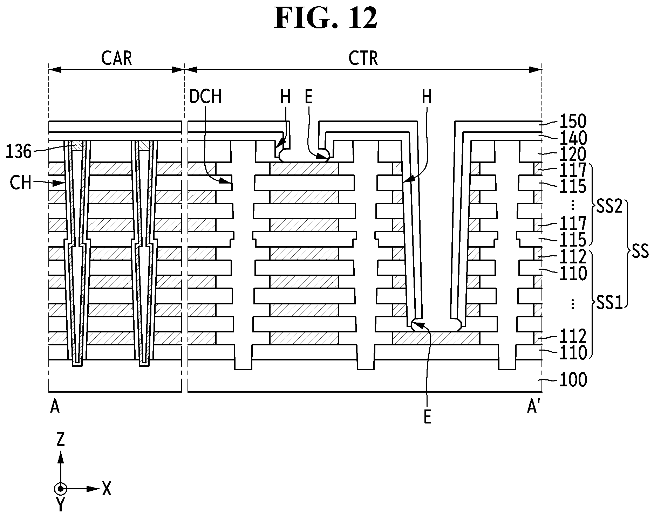

Referring to FIG. 12, exposed portions of the mold insulating films (110 and 115) and portions of the first spacers 140 may be removed, thereby forming expansion holes E. The expansion holes E may be formed below the contact holes H. The upper surfaces of the gate electrodes (112 and 117) may be exposed through the expansion holes E. For example, the mold insulating films (110 and 115) and the first spacers 140 may include silicon oxide and may be removed by a wet etching process. The sidewalls of the expansion holes E may bulge toward the mold insulating films (110 and 115) and the first spacers 140.

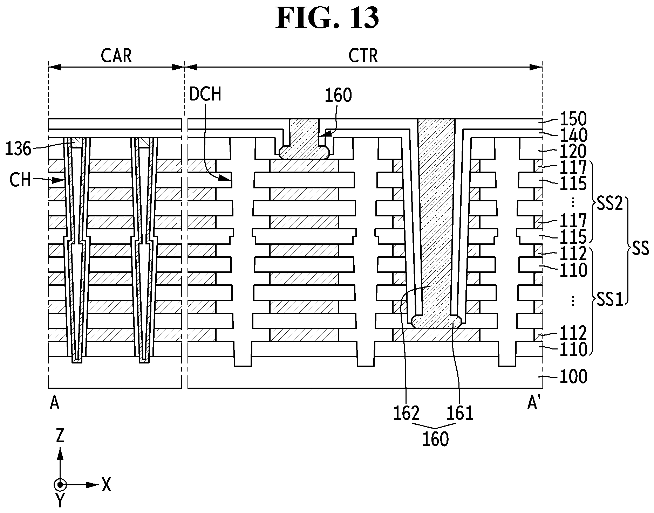

Referring to FIG. 13, contacts 160 filling the expansion holes E and the contact holes H may be formed. The contacts 160 may contact the corresponding gate electrodes (112 and 117).

Thereafter, referring to FIG. 2, a first inter-wiring insulating film 170 and a first wiring structure 180 may be formed on the stacked structure SS. Through these steps, the semiconductor device described above with reference to FIG. 2 may be manufactured.

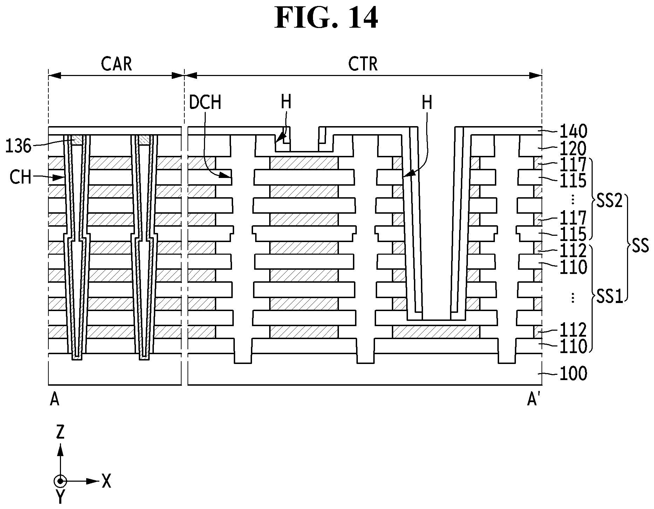

Alternatively, referring to FIG. 14, after the process shown in FIG. 11, horizontal portions of the second spacers 150 on the top surface of the first spaces 140 may be removed.

Thereafter, similar to the process shown in FIG. 12, exposed portions of the mold insulating films (110 and 115) and portions of the first spacers 140 may be removed, thereby forming expansion holes E. The expansion holes E may be formed below the contact holes H. The upper surfaces of the gate electrodes (112 and 117) may be exposed through the expansion holes E. For example, the mold insulating films (110 and 115) and the first spacers 140 may include silicon oxide and may be removed by a wet etching process. The sidewalls of the expansion holes E may bulge toward the mold insulating films (110 and 115) and the first spacers 140.

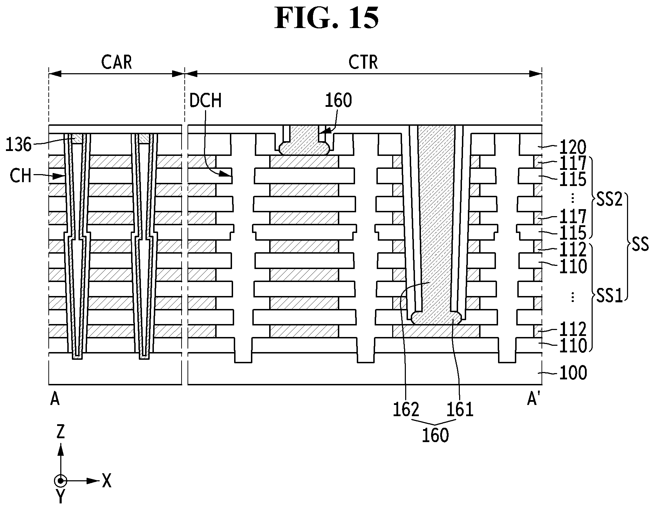

Referring to FIG. 15, contacts 160 filling the expansion holes E and the contact holes H may be formed. The contacts 160 may contact the corresponding gate electrodes (112 and 117).

Thereafter, referring to FIG. 4, a first inter-wiring insulating film 170 and a first wiring structure 180 may be formed on the stacked structure SS. Through these steps, the semiconductor device described above with reference to FIG. 4 may be manufactured.

FIGS. 14 and 15 are diagrams illustrating intermediate steps of a method for manufacturing a semiconductor device according to some embodiments. For convenience of explanation, redundant descriptions previously explained with reference to FIGS. 1 through 13 will be briefly described or omitted. FIG. 14 is a diagram for explaining the manufacturing process following that illustrated in FIG. 10.

Referring to FIG. 14, portions of second spacers 150 and first spacers 140 on the bottom surfaces of contact holes H, and portions of the second spacers 150 on an interlayer insulating film 120 may be removed. Accordingly, the interlayer insulating film 120 may be exposed. The portions of the first spacers 140 and second spacers 150 on the bottom surfaces of the contact holes H and the portions of the second spacers 150 on the interlayer insulating film 120 may be removed by, for example, an etch-back process. At this time, portions of mold insulating films (110 and 115) exposed by the removal of the portions of the first spacers 140 and second spacers 150 may also be removed.

Referring to FIG. 15, expansion holes E may be formed as described above with reference to FIG. 12. Contacts 160 filling the expansion holes E and the contact holes H may be formed. The contacts 160 may contact corresponding gate electrodes (112 and 117).

Thereafter, referring to FIG. 4, a first inter-wiring insulating film 170 and a first wiring structure 180 may be formed on a stacked structure SS. Through these processes, the semiconductor device described above with reference to FIG. 4 may be manufactured.

If only the first spacers 140 are formed on the sidewalls of the contact holes H and portions of the first spacers 140 on the bottom surfaces of the contact holes H are removed, portions of the first spacers 140 on the sidewalls of the contact holes H, the interlayer insulating film 120, and the mold insulating films (110 and 115) may also be removed together. As a result, the contacts 160 may not be electrically insulated from non-corresponding gate electrodes (112 and 117).

However, in the method for manufacturing the semiconductor memory device according to some embodiments, the second spacers 150, different from the first spacers 140, are formed on the first spacers 140, and then an etch-back process is performed. Accordingly, during the etch-back process, the portions of the first spacers 140 on the sidewalls of the contact holes H may be protected by the second spacers 150. Therefore, the contacts 160 may be electrically connected to the corresponding gate electrodes (112 and 117) while being insulated from other gate electrodes (112 and 117). Therefore, a semiconductor memory device with improved reliability can be provided.

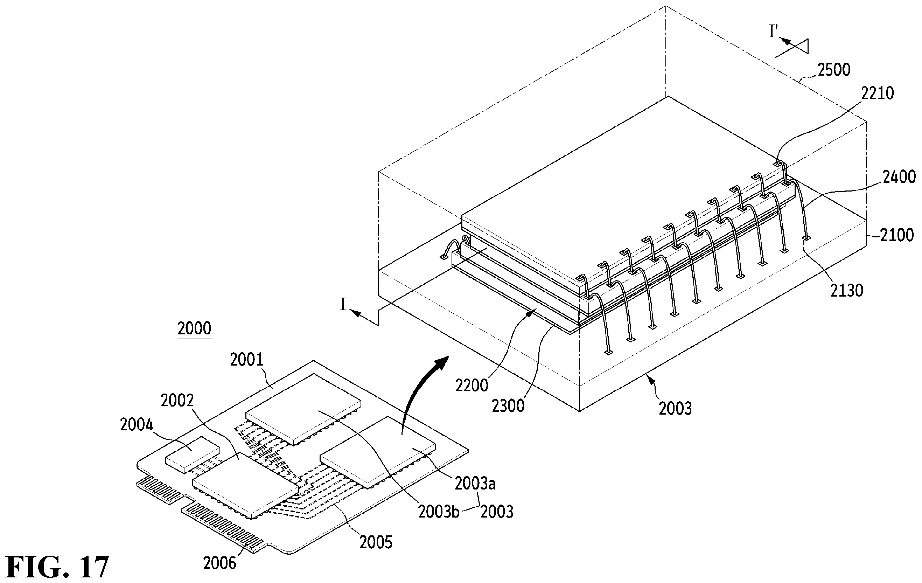

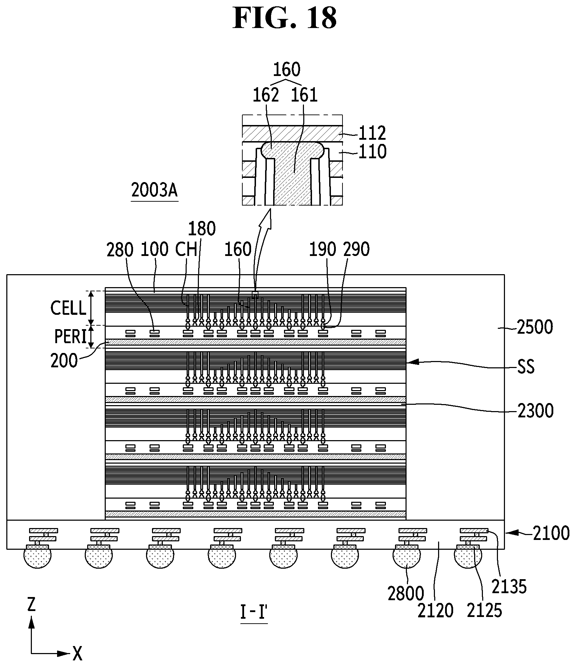

FIG. 16 is an example block diagram illustrating an electronic system according to some embodiments. FIG. 17 is an example perspective view illustrating an electronic system according to some embodiments. FIG. 18 is a schematic cross-sectional view taken along line I-I' of FIG. 17. For convenience of explanation, redundant descriptions previously explained with reference to FIGS. 1 through 15 will be briefly described or omitted.

Referring to FIG. 16, an electronic system 1000 according to some embodiments may include a semiconductor memory device 1100 and a controller 1200 electrically connected to the semiconductor memory device 1100. The electronic system 1000 may be a storage device including at least one semiconductor memory device 1100 or an electronic device including the storage device. For example, the electronic system 1000 may be a solid-state drive (SSD) device, a Universal Serial Bus (USB), a computing system, a medical device, or a communication device, including at least one semiconductor memory device 1100.

The semiconductor memory device 1100 may be a nonvolatile memory device (e.g., a NAND flash memory device) and may include at least one of the semiconductor memory devices described above with reference to FIGS. 1 through 8. The semiconductor memory device 1100 may include a first structure 1100F and a second structure 1100S on the first structure 1100F.

The first structure 1100F may be a peripheral circuit structure including a decoder circuit 1110, a page buffer 1120, and a logic circuit 1130. The first structure 1100F may correspond to the peripheral circuit structure PERI described above with reference to FIGS. 1 through 8.

The second structure 1100S may include a common source line CSL, a plurality of bitlines BL, and a plurality of cell strings CSTR. The bitlines BL may be two-dimensionally arranged in a plane including the first and second directions X and Y. For example, the bitlines BL may extend in the second direction Y and be spaced apart from each other along the first direction X. A plurality of cell strings CSTR may be connected in parallel to the corresponding bitlines BL. The cell strings CSTR may be commonly connected to the common source line CSL. That is, the cell strings CSTR may be disposed between the bitlines BL and the common source line CSL.

Each of the cell strings CSTR may include a ground selection transistor GST connected to the common source line CSL, a string selection transistor SST connected to one of the bitlines BL, and a plurality of memory cell transistors MCT disposed between the ground selection transistor GST and the string selection transistor SST. Each of the memory cell transistors MCT may include a data storage element. The ground selection transistor GST, the string selection transistor SST, and the memory cell transistors MCT may be connected in series in the third direction Z.

The common source line CSL may be commonly connected to the sources of the ground selection transistors GST. Additionally, between the common source line CSL and the bitlines BL, a ground selection line GSL, a plurality of wordlines WL, and a string selection line SSL may be arranged. The ground selection line GSL may serve as the gate electrodes of the ground selection transistors GST, the wordlines WL may serve as the gate electrodes of the memory cell transistors MCT, and the string selection line SSL may serve as the gate electrodes of the string selection transistors SST.

In some embodiments, erase control transistors may be further arranged between the common source line CSL and the ground selection transistors GST. The common source line CSL may be commonly connected to the sources of the erase control transistors. Additionally, an erase control line may be arranged between the common source line CSL and the ground selection line GSL. The erase control line may serve as the gate electrodes of the erase control transistors. The erase control transistors may perform an erase operation on a memory cell array using gate-induced drain leakage (GIDL).

The cell strings CSTR may be electrically connected to the decoder circuit 1110 through the wordlines WL, at least one string selection line SSL, and at least one ground selection line GSL. The cell strings CSTR may also be electrically connected to the page buffer 1120 through the bitlines BL.

The second structure 1100S may correspond to the memory cell structure CELL described above with reference to FIGS. 1 through 8. Although not illustrated, the second structure 1100S may further include various sub-circuits such as an input/output circuit, a voltage generation circuit for generating various voltages required for the operation of the semiconductor memory device 1100, and an error correction circuit for correcting errors in data read from the memory cell array.

The decoder circuit 1110 may select at least one of a plurality of memory cell blocks in response to an address ADDR, and may select at least one wordline WL, at least one string selection line SSL, and at least one ground selection line GSL of the selected memory cell blocks. Additionally, the decoder circuit 1110 may deliver a voltage for performing a memory operation to the wordline WL of the selected memory cell block.

The page buffer 1120 may be connected to the memory cell array through the bitlines BL. The page buffer 1120 may operate as a write driver or a sense amplifier. Specifically, during a program operation, the page buffer 1120 may operate as a write driver to apply a voltage corresponding to data to be stored in the memory cell array to the bitlines BL. Meanwhile, during a read operation, the page buffer 1120 may operate as a sense amplifier to sense data DATA stored in the memory cell array.

The logic circuit 1130 may be connected to the decoder circuit 1110, the input/output circuit, and the voltage generation circuit. The logic circuit 1130 may control the overall operation of the semiconductor memory device 1100. The logic circuit 1130 may generate various internal control signals used within the semiconductor memory device 1100 in response to control signals. For example, during a memory operation such as a program operation or an erase operation, the logic circuit 1130 may control the levels of voltages provided to the wordlines WL and the bitlines BL.

In some embodiments, the common source line CSL and the cell strings CSTR may be electrically connected to the decoder circuit 1110 through first connection wirings 1115 extending from the first structure 1100F to the second structure 1100S. The first connection wirings 1115 may correspond to the gate contacts 160 described above with reference to FIGS. 1 through 8.

In some embodiments, the bitlines BL may be electrically connected to the page buffer 1120 through second connection wirings 1125.

The semiconductor memory device 1100 may communicate with the controller 1200 through input/output pads 1101 electrically connected to the logic circuit 1130. The input/output pads 1101 may be electrically connected to the logic circuit 1130 via input/output connection wirings 1135 extending from the first structure 1100F to the second structure 1100S.

The controller 1200 may include a processor 1210, a NAND controller 1220, and a host interface 1230. In some embodiments, the electronic system 1000 may include a plurality of semiconductor memory devices 1100, in which case the controller 1200 may control the plurality of semiconductor memory devices 1100.

The processor 1210 may control the overall operation of the electronic system 1000, including the controller 1200. The processor 1210 may operate according to predefined firmware and control access to the semiconductor memory device 1100 via the NAND controller 1220. The NAND controller 1220 may include a NAND interface 1221 that handles communication with the semiconductor memory device 1100. Through the NAND interface 1221, control commands for controlling the semiconductor memory device 1100, data to be written to the memory cell transistors MCT of the semiconductor memory device 1100, and data to be read from the memory cell transistors MCT may be transmitted. The host interface 1230 may provide communication functions between the electronic system 1000 and an external host. Upon receiving control commands from an external host through the host interface 1230, the processor 1210 may control the semiconductor memory device 1100 in response to the control commands.

Referring to FIGS. 17 and 18, the electronic system according to some embodiments may include a main substrate 2001, a main controller 2002 mounted on the main substrate 2001, one or more semiconductor packages 2003, and a dynamic random-access memory (DRAM) 2004. The semiconductor package 2003 and the DRAM 2004 may be connected to the main controller 2002 via wiring patterns 2005 formed on the main substrate 2001.

The main substrate 2001 may include a connector 2006 that includes a plurality of pins coupled to an external host. The number and arrangement of the plurality of pins in the connector 2006 may vary depending on the communication interface between an electronic system 2000 and the external host. In some embodiments, the electronic system 2000 may communicate with the external host according to an several interface such as USB, Peripheral Component Interconnect-Express (PCI-Express), Serial Advanced Technology Attachment (SATA), and M-Phy for Universal Flash Storage (UFS). In some embodiments, the electronic system 2000 may operate using power supplied from the external host through the connector 2006. The electronic system 2000 may further include a power management integrated circuit (PMIC) for distributing power supplied from the external host to the main controller 2002 and the semiconductor package 2003.

The main controller 2002 may write data to or read data from the semiconductor package 2003, thereby improving the operating speed of the electronic system 2000.

The DRAM 2004 may serve as a buffer memory to mitigate speed differences between the semiconductor package 2003, which is a data storage space, and the external host. The DRAM 2004 included in the electronic system 2000 may also operate as cache memory, providing temporary data storage space for control operations for the semiconductor package 2003. When the DRAM 2004 is included in the electronic system 2000, the main controller 2002 may further include a DRAM controller to control the DRAM 2004, in addition to a NAND controller for controlling the semiconductor package 2003.

The semiconductor package 2003 may include a first semiconductor package 2003a and a second semiconductor package 2003b spaced apart from each other. The first and second semiconductor packages 2003a and 2003b may be semiconductor packages including a plurality of semiconductor chips 2200. The first and second semiconductor packages 2003a and 2003b may each include a package substrate 2100, semiconductor chips 2200 on the package substrate 2100, adhesive layers 2300 disposed on the lower surfaces of the semiconductor chips 2200, connection structures 2400 electrically connecting the semiconductor chips 2200 to the package substrate 2100, and a molding layer 2500 covering the semiconductor chips 2200 and the connection structures 2400, on the package substrate 2100.

The package substrate 2100 may be a printed circuit board (PCB) including package upper pads 2130. Each of the semiconductor chips 2200 may include input/output pads 2210. The input/output pads 2210 may correspond to the input/output pads 1101 of FIG. 16.

**In** some embodiments, the connection structures 2400 may be bonding wires electrically connecting the input/output pads 2210 and the package upper pads 2130. Therefore, in each of the first and second semiconductor packages 2003a and 2003b, the semiconductor chips 2200 may be electrically connected to each other in a bonding-wire method, and may be electrically connected to the package upper pads 2130 of the package substrate 2100. **In** some embodiments, in each of the first and second semiconductor packages 2003a and 2003b, the semiconductor chips 2200 may be electrically connected to each other via connection structures including through-silicon vias (TSVs) instead of bonding wire-type connection structures 2400.

**In** some embodiments, the main controller 2002 and the semiconductor chips 2200 may be included in a single package. **In** some embodiments, the main controller 2002 and the semiconductor chips 2200 may be mounted on a separate interposer substrate, different from the main substrate 2001, and may be electrically connected to each other through wiring formed on the interposer substrate.

In some embodiments, the package substrate 2100 may be a PCB. The package substrate 2100 may include a package substrate body 2120, package upper pads 2130 disposed on the upper surface of the package substrate body 2120, lower pads 2125 disposed on or exposed through the lower surface of the package substrate body 2120, and internal wirings 2135 electrically connecting the upper pads 2130 and the lower pads 2125 within the package substrate body 2120. The upper pads 2130 may be electrically connected to the connection structures 2400. The lower pads 2125 may be connected to wiring patterns 2005 on the main substrate 2001 of the electronic system 2000, as illustrated in FIG. 17, through conductive connection portions 2800.

In the electronic system 2000 according to some embodiments, each of the semiconductor chips 2200 may include the semiconductor memory device described above with reference to FIGS. 1 through 8. For example, each of the semiconductor chips 2200 may include a memory cell structure CELL and a peripheral circuit structure PERI. For example, the memory cell structure CELL may include the first substrate 100, the stacked structure SS, the channel structures CH, the gate contacts 160, and the first wiring structure 180 described above with reference to FIGS. 1 through 8. Each of the gate contacts 160 may include an extension portion 161 and an expansion portion 162. The peripheral circuit structure PERI may include a second substrate 200 and a second wiring structure 280. For example, the memory cell structure CELL and the peripheral circuit structure PERI may be bonded to each other through first bonding metals 190 and second bonding metals 290.

Although the embodiments of the present disclosure have been described with reference to the accompanying drawings, the present disclosure is not limited to these embodiments and may be manufactured in various other forms. Those skilled in the art will understand that the technical scope or essential characteristics of the present disclosure can be modified and implemented in other specific forms without departing from the scope of the invention. Therefore, the embodiments described above should be understood as being illustrative in all respects and not limiting.

Embodiments are set out in the following clauses:
Clause 1. A semiconductor memory device comprising:
   a first substrate;
   a stacked structure on the first substrate, the stacked structure including mold insulating films and gate electrodes alternately stacked;
   a gate contact penetrating at least a part of the stacked structure and electrically connected to one of the gate electrodes;
   a first spacer on sidewalls of the gate contact; and
   a second spacer between the gate contact and the first spacer, the second spacer including polysilicon.
Clause 2. The semiconductor memory device of clause 1, wherein the first spacer includes a different material from the second spacer.
Clause 3. The semiconductor memory device of clause 1 or clause 2, wherein a bottom surface of the second spacer is positioned above a bottom surface of the first spacer.
Clause 4. The semiconductor memory device of any of clauses 1-3, wherein the mold insulating films include a different material from the first spacer.
Clause 5. The semiconductor memory device of any of clauses 1-4, wherein at least a part of the gate contact is disposed between the one of the gate electrodes and the second spacer.
Clause 6. The semiconductor memory device of any of clauses 1-5, wherein the first spacer further extends along an upper surface of the stacked structure.
Clause 7. The semiconductor memory device of any of clauses 1-6, further comprising:
   a channel structure penetrating the stacked structure,
   wherein at a first height, the channel structure includes a bent portion, and the gate contact is free of a bent portion.
Clause 8. The semiconductor memory device of any of clauses 1-7, further comprising:
   a second substrate and peripheral circuit elements on the second substrate,
   wherein the peripheral circuit elements are disposed between the first substrate and the second substrate.
Clause 9. The semiconductor memory device of any of clauses 1-8, further comprising:
   a second substrate and peripheral circuit elements on the second substrate,
   wherein the stacked structure is disposed between the first substrate and the peripheral circuit elements.
Clause 10. The semiconductor memory device of any of clauses 1-9, further comprising:
   a channel structure penetrating the stacked structure,
   wherein
   the channel structure includes a semiconductor film and a data storage film interposed between the semiconductor film and the gate electrodes, and
   one end of the semiconductor film penetrates the data storage film and contacts the first substrate.
Clause 11. The semiconductor memory device of any of clauses 1-9, further comprising:
   a channel structure penetrating the stacked structure; and
   a source layer between the first substrate and the stacked structure,
   wherein
   the channel structure includes a semiconductor film and a data storage film interposed between the semiconductor film and the gate electrodes, and
   the source layer penetrates the data storage film and contacts side surfaces of the semiconductor film.
Clause 12. The semiconductor memory device of any of clauses 1-9, further comprising:
   a channel structure penetrating the stacked structure,
   wherein
   the channel structure includes a semiconductor film, a data storage film interposed between the semiconductor film and the gate electrodes, and a source pattern interposed between the first substrate and the semiconductor film and between the first substrate and the data storage film, and
   one end of the semiconductor film penetrates the data storage film and contacts the source pattern.
Clause 13. An electronic system comprising:
   a main substrate;
   a semiconductor memory device on the main substrate; and
   a controller electrically connected to the semiconductor memory device, on the main substrate,
   wherein the semiconductor memory device includes: a stacked structure including mold insulating films and gate electrodes alternately stacked; a gate contacts penetrating at least a part of the stacked structure and electrically connected to one of the gate electrodes; a first spacers on sidewalls of the gate contacts; and a second spacers including polysilicon, between the gate contacts and the first spacers.
Clause 14. The electronic system of clause 13, wherein
   each of the gate contacts includes an extension portion extending in a vertical direction and a bulge portion protruding in a horizontal direction at one end of the extension portion and contacting a the one of the corresponding gate electrodes, and
   at least a parts of a bottom surfaces of the second spacers contacts the bulge portion.

## Claims

1. A semiconductor memory device (1100) comprising:
a stacked structure (SS) including mold insulating films (110, 115) and gate electrodes (112, 117) alternately stacked in a vertical direction (Z);
a gate contact (160) penetrating at least a part of the stacked structure (SS) and electrically connected to one of the gate electrodes (112, 117);
a first spacer (140) on sidewalls of the gate contact; and
a second spacer (150) between the gate contact (160) and the first spacer (140),
wherein
the gate contact (160) includes an extension portion (161) extending in the vertical direction and a bulge portion (162) protruding in a horizontal direction (X, Y) at one end of the extension portion (161) and contacting the one of the gate electrodes (112, 117), and
at least a part of a bottom surface of the second spacer (150) contacts the bulge portion (162).

2. The semiconductor memory device (1100) of claim 1, wherein the first spacer (140) and the second spacer (150) include different materials.

3. The semiconductor memory device (1100) of claim 1 or claim 2, wherein at least a part of the first spacer (140) contacts the bulge portion (162).

4. The semiconductor memory device (1100) of any preceding claim, wherein the second spacer (150) further extends along an upper surface of the stacked structure (SS).

5. The semiconductor memory device (1100) of any preceding claim, wherein in the vertical direction (Z), a thickness of the bulge portion (162) is smaller than a thickness of one of the mold insulating films (110, 115) in which the bulge portion (162) is disposed.

6. The semiconductor memory device (1100) of any preceding claim, further comprising:
a channel structure (CH) penetrating the stacked structure (SS),
wherein at a first height, the channel structure (CH) includes a bent portion, and the extension portion (161) does not include a bent portion.

7. A semiconductor memory device (1100) comprising:
a first substrate (100);
a stacked structure (SS) on the first substrate (100), the stacked structure (SS) including mold insulating films (110, 115) and gate electrodes (112, 117) alternately stacked;
a gate contact (160) penetrating at least a part of the stacked structure (SS) and electrically connected to one of the gate electrodes (112, 117);
a first spacer (140) on sidewalls of the gate contact (160); and
a second spacer (150) between the gate contact (160) and the first spacer (140), the second spacer (150) including polysilicon.

8. The semiconductor memory device (1100) of claim 7, wherein the first spacer (140) includes a different material from the second spacer (150).

9. The semiconductor memory device (1100) of claim 7 or claim 8, wherein a bottom surface of the second spacer (150) is positioned above a bottom surface of the first spacer (140).

10. The semiconductor memory device (1100) of any of claims 7-9, wherein the mold insulating films (110, 115) include a different material from the first spacer (140).

11. The semiconductor memory device (1100) of any of claims 7-10, wherein at least a part of the gate contact (160) is disposed between the one of the gate electrodes (112, 117) and the second spacer (150).

12. The semiconductor memory device (1100) of any of claims 7-11, wherein the first spacer (140) further extends along an upper surface of the stacked structure (SS).

13. The semiconductor memory device (1100) of any of claims 7-12, further comprising:
a channel structure (CH) penetrating the stacked structure (SS),
wherein at a first height, the channel structure (CH) includes a bent portion, and the gate contact (160) is free of a bent portion.

14. The semiconductor memory device (1100) of any of claims 7-13, further comprising:
a second substrate (200) and peripheral circuit elements (PT) on the second substrate (200),
wherein the peripheral circuit elements (PT) are disposed between the first substrate (100) and the second substrate (200).

15. The semiconductor memory device (1100) of any of claims 7-14, further comprising:
a second substrate (200) and peripheral circuit elements (PT) on the second substrate (200),
wherein the stacked structure (SS) is disposed between the first substrate (100) and the peripheral circuit elements (PT).
